# EUROPEAN PATENT SPECIFICATION

(11) **EP 3 821 480 B1**
(45) Date of publication and mention of the grant of the patent: **18.05.2022**
(21) Application number: 19820653.4
(22) Date of filing: 11.09.2019
(51) Int. Cl.: H01M 50/20, B60L 53/80, H01M 50/256

(54) **POWER SUPPLY MOUNTING POSITION DETECTING DEVICE, METHOD, AND POWER SUPPLY**
VORRICHTUNG ZUR POSITIONSERFASSUNG EINES NETZTEILS, VERFAHREN UND NETZTEIL
DISPOSITIF DE DÉTECTION DE POSITION DE MONTAGE D'ALIMENTATION ÉLECTRIQUE, PROCÉDÉ ET ALIMENTATION ÉLECTRIQUE

(43) Date of publication of application: 19.05.2021
(73) Proprietor: SZ DJI Technology Co., Ltd., Shenzhen, Guangdong 518057 (CN)
(72) Inventor: ZHANG, Caihui, Guangdong 518057 (CN); LI, Peng, Guangdong 518057 (CN); ZHANG, Ruiqiang, Guangdong 518057 (CN)
(74) Representative: Goddar, Heinz J.
(86) International application number: PCT/CN2019/105443
(87) International publication number: WO 2021/046769

(56) References cited:
- WO-A1-2019/129285
- CN-A- 105 857 048
- CN-A- 105 946 609
- CN-A- 105 946 609
- CN-A- 106 080 203
- CN-A- 107 223 108
- CN-A- 108 248 566
- CN-A- 108 281 585
- CN-U- 206 179 925
- CN-U- 208 781 917
- JP-A- 2005 285 458

## Description

### TECHNICAL FIELD

The present disclosure relates to the technology field of power supply and, more particularly, to a power supply mounting position detecting device, a method, and a power supply.

### BACKGROUND

Movable platforms, such as unmanned aerial vehicles ("UAVs"), electrical vehicles, have been widely used in various fields, such as agriculture, power line inspection, photography, surveillance, etc. Such movable platforms may need a power supply, such as a battery, to provide electric power for the operations. In many applications, the battery is detachably mounted to the movable platform, such that the battery can be detached from the movable platform for recharge, service, or replacement. In various application scenes, there is an increasing demand on the battery for a high stability of power supply. For example, in the field of UAVs, if the battery is not mounted to the specified position, or if the mounting is not stable, the battery may separate from the UAV after takeoff due to vibrations. This may result in a crash of the UAV, which may further pose safety risk to human beings and other properties.

WO 2019/129285 A1 discloses a battery holder, a power transfer device, an electric vehicle. The battery holder is mounted on the body of the electric vehicle to fix the battery pack, the battery holder includes a fixing bracket, a lock mechanism and a plurality of supporting devices, the lock mechanism is fixed on the fixing bracket, the supporting device is fixed on one side of the fixing bracket facing the battery pack, a plurality of supporting devices are used to provide a plurality of support points that support the battery pack.

CN 105 857 048 A relates to the technical field of electric car power battery replacement equipment, and provides a universalization integrated battery replacement system for an electric car. The universalization integrated battery replacement system comprises a battery box, a frame support arranged below a chassis of the electric car and a quick-changing connector for connecting electric car low-voltage signals and high-voltage circuits. The two sides of the battery box are each provided with a row of cylindrical suspension points. The two sides of the support are provided with fixing mechanisms corresponding to the suspension points. A locking mechanism is further arranged on the support. The locking mechanism comprises an unlocking connecting rod. A row of rotatable spring bolts is uniformly arranged on the connecting rod to be connected with the fixing mechanisms.

CN 108 281 585 A discloses a special bottom support device for a battery box of a novel energy automobile, and belongs to the technical field of accessories of new energy automobiles.

### SUMMARY

The invention is defined by independent claim 1 defining a power supply and independent claim 13 defining a method for determining that the power supply according to claim 1 is mounted at a predetermined mounting position of a battery compartment. Some embodiments of the invention are included in the dependent claims, the description and the figures.

It shall be understood that different aspects of the present disclosure can be appreciated individually, collectively, or in combination with each other. Various aspects of the present disclosure described herein may be applied to any of the particular applications set forth below or for any other types of devices other than UAVs, including, for example, ground vehicles, water surface vehicles, underwater vehicles, and space vehicles.

Other objects and features of the present disclosure will become apparent by a review of the specification, claims, and appended figures.

### BRIEF DESCRIPTION OF THE DRAWINGS

The novel features of the present disclosure are set forth with particularity in the appended claims. A better understanding of the features and advantages of the present disclosure will be obtained by referencing to the following detailed description that sets forth illustrative embodiments, in which the principles of the present disclosure are utilized, and the accompanying drawings of which:
FIG. 1 is a schematic perspective view of a power supply, in accordance with an embodiment of the present disclosure.
FIG. 2 is a schematic perspective view of a handle of the power supply, in accordance with an embodiment of the present disclosure.
FIG. 3 is a cross-sectional view of the power supply and a battery compartment, showing that the power supply has not been mounted to a predetermined mounting position of the battery compartment, in accordance with an embodiment of the present disclosure.
FIG. 4 is a cross-sectional view of a part of the power supply, showing a detecting device when the power supply has not been mounted to the predetermined mounting position, in accordance with an embodiment of the present disclosure.
FIG. 5 is a cross-sectional view of the power supply and a battery compartment, showing that the power supply has been mounted to a predetermined mounting position of the battery compartment, in accordance with an embodiment of the present disclosure.
FIG. 6 is a cross-sectional view of a part of the power supply, showing the detecting device when the power supply has been mounted to the predetermined mounting position, in accordance with an embodiment of the present disclosure.
FIG. 7 is a cross-sectional view of a part of the power supply, showing a detecting device, in accordance with another embodiment of the present disclosure.
FIG. 8 is a cross-sectional view of a part of the power supply and a battery compartment, in accordance with another embodiment of the present disclosure.
FIG. 9 is a schematic illustration of a power supply and a battery compartment, in accordance with another embodiment of the present disclosure.
FIG. 10 is a cross-sectional view of a part of the power supply, showing a detecting device, in accordance with another embodiment of the present disclosure.
FIG. 11 is a schematic illustration of a portion of a circuit, in accordance with an embodiment of the present disclosure.
FIG. 12 is a schematic illustration of another portion of the circuit, in accordance with an embodiment of the present disclosure.
FIG. 13 is a top view of an example of a movable platform, in accordance with an embodiment of the present disclosure.
FIG. 14 is a flow chart illustrating a method for detecting a position of a power supply, in accordance with an embodiment of the present disclosure.
FIG. 15 is a flow chart illustrating a method for detecting a position of a power supply, in accordance with another embodiment of the present disclosure.

### DESCRIPTION OF THE EMBODIMENTS

Technical solutions of the present disclosure will be described in detail with reference to the drawings. It will be appreciated that the described embodiments represent some, rather than all, of the embodiments of the present disclosure. Other embodiments conceived or derived by those having ordinary skills in the art based on the described embodiments without inventive efforts should fall within the scope of the present disclosure. Example embodiments will be described with reference to the accompanying drawings, in which the same numbers refer to the same or similar elements unless otherwise specified.

As used herein, when a first component (or unit, element, member, part, piece) is referred to as "coupled," "mounted," "fixed," "secured" to or with a second component, it is intended that the first component may be directly coupled, mounted, fixed, or secured to or with the second component, or may be indirectly coupled, mounted, or fixed to or with the second component via another intermediate component. The terms "coupled," "mounted," "fixed," and "secured" do not necessarily imply that a first component is permanently coupled with a second component. The first component may be detachably coupled with the second component when these terms are used. The term "coupled" may include mechanical and/or electrical coupling. When a first item is electrically coupled with a second item, the electrical coupling may include any suitable forms of electrical connections, such as, for example, wired and wireless connections.

When a first component is referred to as "connected" to or with a second component, it is intended that the first component may be directly connected to or with the second component or may be indirectly connected to or with the second component via an intermediate component. The connection may include mechanical and/or electrical connections. The electrical connection may be wired or wireless. The connection may be permanent or detachable.

When a first component is referred to as "disposed," "located," or "provided" on a second component, the first component may be directly disposed, located, or provided on the second component or may be indirectly disposed, located, or provided on the second component via an intermediate component. When a first component is referred to as "disposed," "located," or "provided" in a second component, the first component may be partially or entirely disposed, located, or provided in, inside, or within the second component. The terms "perpendicular," "horizontal," "left," "right," "up," "upward," "down," "downward," "front," "rear," and similar expressions used herein are merely intended for description, and may be relative to a view illustrated in a drawing. The term "communicatively coupled" indicates that related items are coupled through a communication channel, such as a wired or wireless communication channel.

Unless otherwise defined, all the technical and scientific terms used herein have the same or similar meanings as generally understood by one of ordinary skill in the art. As described herein, the terms used in the specification of the present disclosure are intended to describe example embodiments, instead of limiting the present disclosure. The term "and/or" used herein includes any suitable combination of one or more related items listed.

Further, when an embodiment illustrated in a drawing shows a single element, it is understood that the embodiment may include a plurality of such elements. Likewise, when an embodiment illustrated in a drawing shows a plurality of such elements, it is understood that the embodiment may include only one such element. The number of elements illustrated in the drawing is for illustration purposes only, and should not be construed as limiting the scope of the embodiment. Moreover, unless otherwise noted, the embodiments shown in the drawings are not mutually exclusive, and they may be combined in any suitable manner. For example, elements shown in one embodiment but not another embodiment may nevertheless be included in the other embodiment.

The following descriptions explain example embodiments of the present disclosure, with reference to the accompanying drawings. Unless otherwise noted as having an obvious conflict, the embodiments or features included in various embodiments may be combined. The following embodiments do not limit the sequence of execution of the steps included in the disclosed methods. The sequence of the steps may be any suitable sequence, and certain steps may be repeated.

To address at least one of the above-described issues existing in the current technologies, such as the issue of power supply (e.g., a battery or a battery pack) falling off from a UAV due to unsecure mounting that may cause crash of the UAV, the present disclosure provides a technical solution that can detect whether a power supply (e.g., a battery or battery pack) has been mounted to, or at, a mounting position or location of a mounting structure. The mounting position or location of a mounting structure maybe a desired or specified predetermined mounting position or location of a mounting structure, such as a mounting bracket of a battery compartment. The present technical solution may include at least one detecting device that may include a sensing assembly. In some embodiments, two or more detecting devices may be included. The sensing assembly may include be a non-contact sensing assembly. In some embodiments, the sensing assembly may include a signaling element and a sensing element cooperating with the signaling element to detect the mounting position of the power supply. For example, the sensing element may generate an indication signal when the signaling element is location within a sensible range such that the sensing element can detect a signal generated by the signaling element. The indication signal may indicate whether the power supply has been mounted to the desired predetermined mounting position at the battery compartment. In some embodiments, the signaling element and the sensing element may be non-contacting elements. That is, the sensing signal generated by the signaling element may be received or detected by the sensing element through a non-contacting, wireless manner.

In some embodiments, the sensing assembly may include a pair of a magnet (or an electric coil, as an example of the signaling element) and a Hall effect sensor (as an example of the sensing element) configured to detect a mounting position of the power supply (e.g., to detect whether the power supply has been reliably mounted at the predetermined mounting position at a battery compartment.

The Hall effect sensor is a magnetic field sensor based on the Hall effect, and may include a Hall component and an accompanying circuit integrated together. According to the Hall effect, when a current I flows through two ends of a semiconductor thin plate, and a magnetic field having an intensity B is applied to the semiconductor thin plate in a direction perpendicular to the plate, then in a direction perpendicular to both the current and the magnetic field, an electric charge under the Lorentz force will generate a difference in electric potential, i.e., a voltage UH (Hall voltage). A Hall effect sensor may be a linear Hall effect sensor or a switch-type Hall effect sensor (e.g., a digital switch-type Hall effect sensor). The use of the magnet and Hall effect sensor as the sensing assembly not only provides a simple and reliable solution, but also reduces the manufacturing cost.

In the technical solution of the present disclosure, a switch-type Hall effect sensor is used as an example for the descriptive purposes. When a magnetic flux intensity sensed by the Hall effect sensor exceeds (i.e., is greater than or equal to) a predetermined magnetic flux intensity BH, an output of the Hall effect sensor may be a predetermined voltage level (e.g., a low voltage lower than a predetermined voltage threshold). A person having ordinary skills in the art can appreciate that the predetermined voltage level output by the Hall effect sensor when the sensed magnetic flux intensity exceeds the predetermined magnetic flux intensity BH may alternatively be a high voltage higher than or equal to the predetermined voltage threshold. The predetermined voltage threshold may be specified based on actual application, which may be 1 V, 3 V, 5 V, etc. In some embodiments, the output from the Hall effect sensor may maintain a low voltage until the magnetic flux intensity reduces to below the predetermined magnetic flux intensity BH.

In some embodiments, the detecting device may include a mechanical movable member. The movable member may be a linkage or any other mechanical structure that is configured to be movable. Each two opposing sides of the power supply may be provided with a detecting device (hence two detecting devices may be provided to detect the mounting position at two sides of the power supply). A person having ordinary skills in the art can appreciate that the technical solution of the present disclosure can include only one detecting device provided at one side of the power supply. For illustrative purposes, the following descriptions use two mechanical movable members respectively provided at two sides of the power supply as an example. The mechanical movable members may be connected with a handle of the power supply. Thus, during the installation and detaching process, the handle of the power supply may be lifted up or lowered down by an operator. The movement of the handle may drive the movable members to move in a space of the first position limiting structure provided in a body of the power supply. The movement of the movable members may change the relative positions of the magnet and the Hall effect sensor, or may otherwise affect the magnetic flux intensity measured or detected by the Hall effect sensor. The movable member may be at least partially disposed inside the body of the power supply, and the restoration member that couples with the movable member may be entirely disposed inside the body of the power supply. This configuration can reduce the exposure of the detecting device to rock, sand, dust, water, and other environmental objects or effect (such as corrosion) that may adversely affect the sensitivity, accuracy, or functionality of the detecting device. Therefore, the disclosed detecting device enables the power supply to be implemented for applications in harsh environments, such as agriculture application, an outdoor power line inspection application, fire and rescue application, a geological survey, natural disaster monitoring and evaluation, etc. The disclosed detecting device has a simple structure, can provide reliable and accurate detection, is dust/sand/rock/water proof, and is cost effective.

In one embodiment, when the power supply is installed to the UAV, the handle is gradually lowered, and the movable members are gradually moved. The relative positions between the magnet and the Hall effect sensor may change, as the magnet and the Hall effect sensor may move closer to one another. As the magnet moves closer to the Hall effect sensor, the magnetic flux intensity from the magnet, as detected by the Hall effect sensor, may increase. When the power supply is mounted to the predetermined mounting position, the magnetic flux intensity detected by the Hall effect sensor may exceed (e.g., be greater than or equal to) the predetermined magnetic flux intensity threshold BH. In some embodiments, an output of the Hall effect sensor may switch from a high voltage to a low voltage. When the power supply is removed from the UAV, the handle on the power supply is lifted up by an operator, causing the movable members to move, thereby changing the relative positions of between the magnet and the Hall effect sensor in an opposite direction that reduces the magnetic flux intensity measured by the Hall effect sensor. When the magnetic flux intensity measured by the Hall effect sensor decrease to below the predetermined magnetic flux intensity threshold BH, the output of the Hall effect sensor switches from the low voltage to the high voltage.

Thus, when an output of the Hall effect sensor is a low voltage, it may indicate that the power supply has been mounted to the predetermined mounting position at a battery compartment. When two detecting devices are used, the outputs of the two Hall effect sensors may be compared by a logic gate circuit. In some embodiments, when both of the two Hall effect sensors output a low voltage, the logic gate circuit may output a signal indicating that the power supply has been mounted to the predetermined mounting position at the battery compartment. When one or both of the two Hall effect sensors output a high voltage, the logic gate circuit may output another signal indicating that the power supply has not been mounted to the predetermined mounting position at the battery compartment. Use of one detecting device may achieve the purpose of detecting the mounting position of the power supply. Use of two detecting devices may further enhance the reliability of the determination of the mounting position of the power supply.

In some embodiments, the relative positions between the magnet and the Hall effect sensor may be fixed. The magnet and the Hall effect sensor may be provided at fixed positions on a body of the power supply on two sides of a movable member. A through hole may be provided on the movable member. When the movable member moves as the handle is moved, the through hole may move relative to the magnet and the Hall effect sensor, thereby affecting the magnetic flux intensity measured by the Hall effect sensor. When the power supply is mounted to the predetermined mounting position, the movable member may be moved to a location such that the through hole is aligned with the magnet and the Hall effect sensor, allowing the Hall effect sensor to measure a magnetic flux intensity that exceeds (e.g., is greater than or equal to) the predetermined magnetic flux intensity BH. As a result, the Hall effect sensor may output a low voltage, indicating that the power supply has been mounted to the predetermined mounting position. When two detecting devices are provided on two sides of the power supply (e.g., left and right sides corresponding to two connecting portions of the handle with the body, or front and back sides at one connecting portion of the handle with the body), the output voltages of the two Hall effect sensors may be compared by a logic gate circuit. When the power supply has not been mounted to the predetermined mounting position, the Hall effect sensor may output a high voltage. When both of the two Hall effect sensors output a low voltage, the logic gate circuit may generate a signal indicating that the power supply has been mounted to the predetermined mounting position. When one or both of the two Hall effect sensors output a high voltage, the logic gate circuit may generate a signal indicating that the power supply has not been mounted to the predetermined mounting position. Use of one detecting device may achieve the purpose of detecting the mounting position of the power supply. Use of two detecting devices may further enhance the reliability of the determination of the mounting position of the power supply.

With the technical solution of the present disclosure, the mounting position of the power supply on the movable platform, such as a UAV may be detected, and an incorrect or improper mounting may be discovered in time to avoid a crash of the UAV caused by the power supply being disconnected from the UAV due to improper mounting. Thus, the safety of the UAV may be significantly improved.

In addition, the disclosed technical solutions have the following advantages. In the technical field of electric vehicles, batteries may be replaceable during the lifetime of the vehicle. When a battery supply shop replaces the battery of the electric vehicle, whether the new battery has been properly installed to the electric vehicle may affect the safety of normal operation. Therefore, in the technical field of electric vehicle, the technical solution of the present disclosure provides a method and structure for determining whether a replaced battery has been properly installed. When the battery has not been mounted at a predetermined mounting position, an indication signal (e.g., an alert message, such as a message in at least one of the following forms: a voice, a light display, etc.) may be generated to notify the operator of the battery supply shop. As a result, safety of the electric vehicle can be improved.

In another technical field of charging and discharging of high voltage battery packs, when charging a battery pack with a high voltage (e.g., 36V or higher), which is higher than a safe voltage for human body, if the charging port of the charger often carries a voltage, it is easy to cause accidental shock to an operator or other safety issues. Therefore, turning on the charger after detecting that the battery to be charged has been properly installed will improve the safety of the charger. The technical solution provides a method and structure for detecting whether the battery has been mounted at a predetermined mounting position. Thus, the battery charging/discharging may be activated only when an indication signal generated by the disclosed detecting device that the battery has been properly mounted to the predetermined mounting position. As a result, safety of charging and discharging of the high voltage battery packs can be improved.

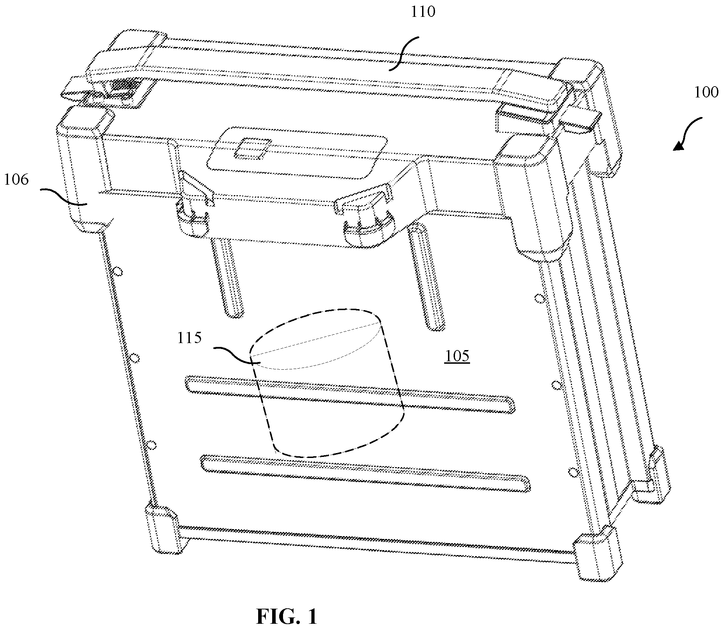

FIG. 1 is a perspective view of a power supply, according to an embodiment of the present disclosure. The power supply 100 may include a body 105. The body 105 may include a housing or shell 106 that defines an accommodating cavity that houses at least one battery 115. For illustrative purposes, one battery 115 is shown. It is understood that more than one battery may be included in the power supply 100. The power supply 100 may include a handle 110 mounted to a top portion of the body 100. The handle 110 may be operated by a user or operator to lift up the power supply 100. For example, the power supply 100 may be detachably mounted to a movable platform, such as a UAV, an electric car, a high voltage large capacity charger, etc.

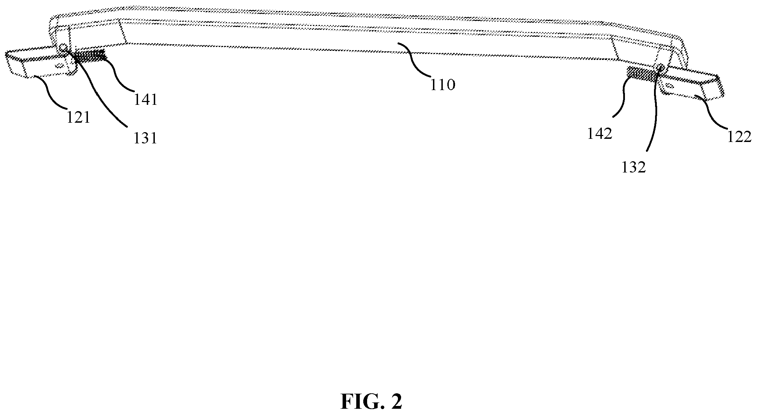

FIG. 2 illustrates connection between the handle 110 and two movable members 121 and 122. For illustrative purposes, other components of the power supply 100 are not shown. The handle 110 may be pivotably connected with the movable members 121 and 122 through pins 131 and 132. For example, a first end of the movable member 121 may be connected with an end (e.g., the left end shown in FIG. 2) of the handle 110 through the pin 131. A first end of the movable member 122 may be connected with an end (e.g., the right end shown in FIG. 2) of the handle 110 through the pin 132. Each movable member may be connected with a restoration member. For example, the movable member 121 may be connected with a restoration member 141 at the first end of the movable member 121. The movable member 122 may be connected with a restoration member 142 at the first end of the movable member 122. The movable member 121 and the restoration member 141 (or the movable member 122 and the restoration member 142) may be part of a detecting device described below. The movable members 121 and 122 may have identical structures. Alternatively, the movable members 121 and 122 may have different structures. The restoration members 141 and 142 may have identical structures. Alternatively, the restoration members 141 and 142 may have different structures.

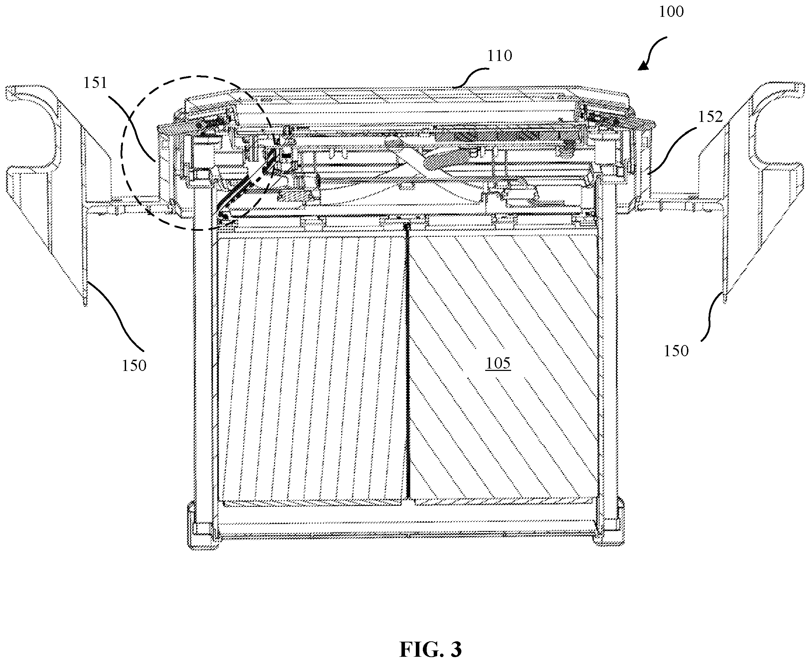

FIG. 3 is a cross-sectional view of the power supply 100 and a battery compartment 150, according to an embodiment of the present disclosure. FIG. 3 shows the power supply 100 in contact with the battery compartment 150, but has not been mounted to the battery compartment 150. As shown in FIG. 3, the battery compartment 150 may include a first mounting bracket 151 and a second mounting bracket 152, respectively disposed at two sides of the battery compartment 150. The power supply 100 may be mounted to the battery compartment 150 from above the battery compartment. That is, the power supply 100 may be vertically inserted into the mounting brackets 151 and 152. When the power supply 100 is mounted to the mounting bracket 151 and 152, the power supply 100 is supported by the mounting brackets 151 and 152. The battery compartment 150 may be a portion on a movable platform, such as a UAV, an electrical car, a high voltage large capacity charger, etc. For example, the battery compartment 150 may be a power supply mounting chamber or frame of a UAV, an electric car, a high voltage large capacity charger, etc. Although FIG. 3 shows that the mounting brackets 151 and 152 have identical structures, they may have different structures in other embodiments.

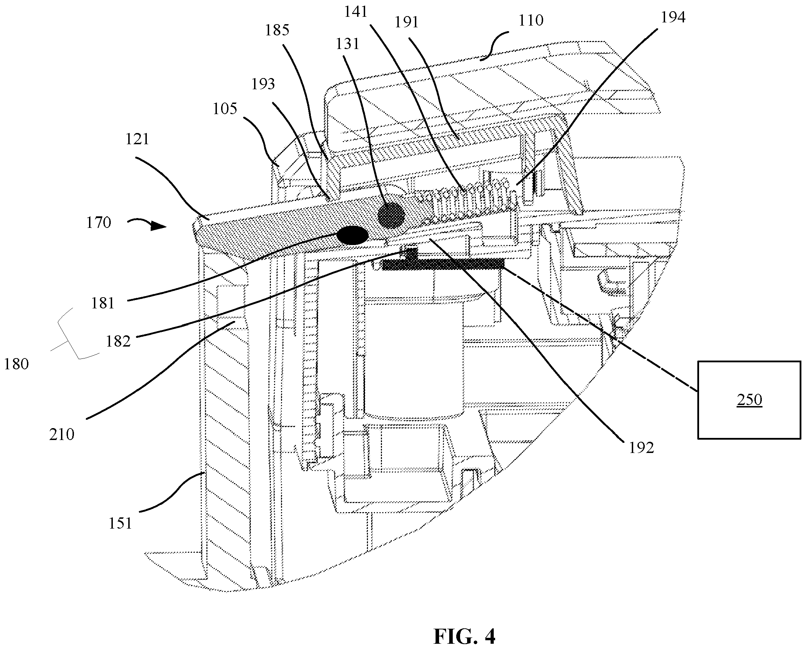

FIG. 4 is a cross-sectional view of a portion of the power supply 100 that is indicated by the dashed circle shown in FIG. 3. FIG. 4 illustrates the details of a detecting device 170 disposed at or operably coupled to the left side of the body of power supply 100 adjacent the left end of the handle 110. In some embodiments, the structures, components, configurations, and the operations at the right side of the power supply 100 may be similar to or identical with those at the left side of the power supply 100, as shown in FIG. 4. For example, another detecting device similar to the detecting device 170 may be provided at the right side of the power supply 100. The detecting device provided at the right side of the power supply 100 may have identical structure as the detecting device 170 provided at the left side shown in FIG. 4. Therefore, the descriptions of the right side detecting device, including the structures, components, configurations, and operations are omitted for simplicity.

The detecting device 170 may include the movable member 121, the restoration member 141, and a sensing assembly 180. The sensing assembly 180 be configured to generate an indication signal based on a location or position of the movable member 121. The sensing assembly 180 may include a signaling element 181 and a sensing element 182 configured to couple with one another through a non-contact, wireless manner, such as through a magnetic field, an electromagnetic field, an optical field, an acoustic field, etc. The use of the non-contact, wireless sensing assembly 180 may reduce the wear and tear of the signaling element 181 and the sensing element 182, prolong the operation lifetime of these components, and provide reliable and accurate detection. The sensing assembly 180 may be configured to generate an indication signal to indicate the state of the power supply 100, such as the position of the power supply 100, for example, whether the power supply 100 is mounted to the mounting bracket 151. Using the indication signal to indicate the state, such as the mounting state of the power supply 100, may improve the response time, and is convenient for users to obtain the installation status of the power supply 100. In some embodiments, a signal generated by the sensing assembly 180 may vary in at least one parameter (e.g., a strength of the signal) based on the mounting position of the power supply 100 with respect to the mounting bracket 151 (or 152). In some embodiments, the sensing element 182 may be electrically connected with the at least one battery 115 to receive electric power.

Although the non-contacting manner is shown in FIG. 4 for the signaling element 181 and the sensing element 182, it is understood that in some embodiments, the interaction manner between the signaling element 181 and the sensing element 182 may also adopt a contacting manner. That is, the sensing assembly 180 may be a contact sensing assembly. For example, the signaling element 181 may be a pressure element configured to generate a pressure, and the sensing element 182 may be a pressure sensor configured to detect a pressure when the sensing element 182 contacts the signaling element 181. The signaling element 181 may apply a pressure on the sensing element 182 when they are in contact with one another. In some embodiments, the sensing element 182 may be a suitable electronic device that generates a voltage signal in response to the pressure. For example, when the movable member 121 is moved to the predetermined location in the first position limiting structure 185, the location of the signaling element 181 may correspond to the location of the sensing element 182, and the signaling element 181 disposed at the bottom surface of the movable member 121 may contact the sensing element 182 disposed at the lower wall 192. When the signaling element 181 contacts the sensing element 182 and applies a pressure on the sensing element 182, the sensing element 182 may generate the first indication signal to indicate that the power supply 100 has been mounted to the mounting position. When the movable member 121 has not been moved to the predetermined location in the first position limiting structure 185, the location of the signaling element 181 may not correspond to the location of the sensing element 182, and the sensing element 182 may not contact the signaling element 181. As a result, the sensing element 182 may not detect a pressure, and may generate the second indication signal indicating that the power supply 100 has not been mounted to the mounting position. Using the indication signal to indicate the state, such as the mounting state of the power supply 100, may improve the response time, and is convenient for users to obtain the installation status of the power supply 100.

The body 105 may include a first position limiting structure 185. The first position limiting structure 185 may include an upper wall 191, a lower wall 192, a left opening 193, and a right end wall 194, which together may define a space for accommodating at least a portion of the movable member 121 and at least a portion of the restoration member 141. For example, the restoration member 141 may be at least partially disposed (e.g., entirely disposed) within the space of the position limiting structure 185. The movable member 121 may be slidable (or movable) along the lower wall 192 of the position limiting structure 185. The movable member 121 may be movably coupled with a first side (e.g., the right end wall 194) of the position limiting structure 185 through the restoration member 141. A first end (e.g., the left end shown in FIG. 4) of the restoration member 141 may be connected with a second end (e.g., the right end shown in FIG. 4) of the movable member 121. A second end (e.g., the right end shown in FIG. 4) of the restoration member 141 may be connected with the right end wall 194 of the first position limiting structure 185. A first end (e.g., the left end shown in FIG. 4) of the movable member 121 may extend out of the position limiting structure 185 (or the body 105) through the left opening 193. The restoration member 141 may be any suitable elastic, resilient, or flexible member, such as a spring, which may provide a restoration force to the movable member 121 when compressed or pulled (e.g., when the length of the restoration member 141 decreases or increases from its original length). Using the restoration force of the restoration member to interact with the movable member eliminate the need for an additional component. The resulting structure is simple and manufacturing cost is low.

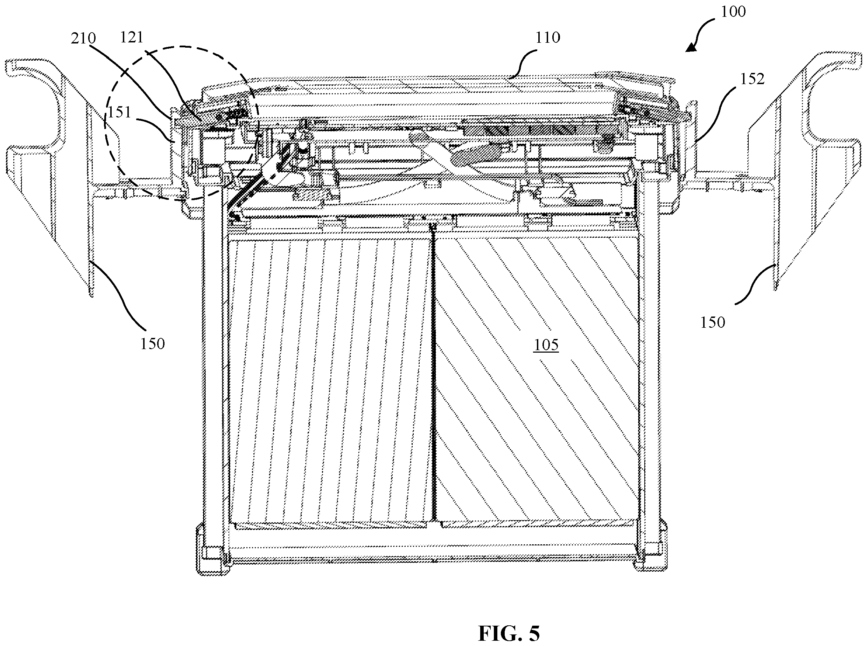

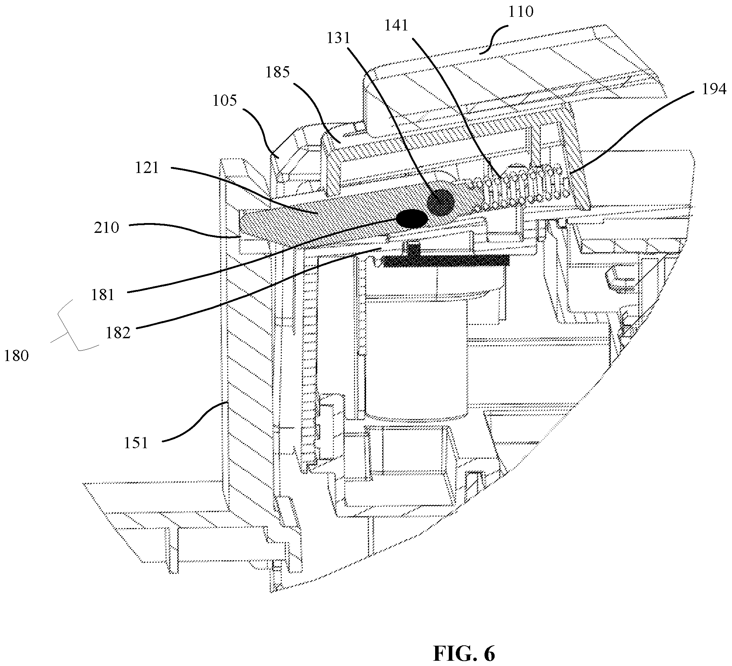

FIG. 4 shows a state in which the movable member 121 is at an extended position, which the first end of the movable member 121 extending out of the body 105. A tip portion of the movable member 121 may contact a top portion of the mounting bracket 151, but the power supply 100 has not yet been mounted to the mounting bracket 151. To mount to the mounting bracket 151, the power supply 100 may be further lowered or inserted downwardly, such that the tip portion of the movable member 121 continues to slide downwardly along the mounting bracket 151 until the tip portion of the movable member 121 engages with a second position limiting structure 210 of the mounting bracket 151, as shown in FIG. 5 and FIG. 6. The second position limiting structure 210 may include a recessed portion (e.g., a hole) in the surface facing the movable member 121 and configured to receive the tip portion of the movable member 121. When the tip portion of the movable member 121 is engaged with the recessed portion of the second position limiting structure 210, the movement of the movable member 121 at the up-down direction is limited, thereby securing the mounting position of the power supply 100 at the predetermined mounting position (e.g., the position at which the movable members 121 and 122 are both engaged with the second position limiting structures provided on the mounting brackets 151 and 152). In some embodiments, the recessed portion may be a snap-fit hole. Securing the power supply at a fixed, predetermined mounting position can improve the safety of the power supply.

In the detecting device 170 shown in FIG. 4, when the handle 110 is lifted by an operator, the handle 110 pulls the pin 131 on the handle 110 to the right (e.g., center direction of the handle 110), causing the movable member 121 to move to the right into the space of the first position limiting structure 185 toward the right end wall of the first position limiting structure 185. The movable member 121 may compress the restoration member 141. In turn, the restoration member 141 may provide a restoration force to push the movable member 121 outward toward the opening of the first position limiting structure 185. The use of the restoration member 141 to couple with the movable member 121 can make the structure simple and reduce the manufacturing cost, and it is convenient for users to install and uninstall the power supply.

In some embodiments, the signaling element 181 may be disposed on the movable member 121. Therefore, the signaling element 181 may move along with the movable member 121. As a result, the relative location relationship between the signaling element 181 and the sensing element 182 may change as the movable member 121 moves. For example, the signaling element 181 may be fixed at a lower surface (e.g., a first side) of the movable member 121, facing the lower wall 192 of the first position limiting structure 185. In some embodiments, the signaling element 181 may be embedded in a recessed portion of the lower surface of the movable member 121. In some embodiments, a portion of the signaling element 181 may be exposed. In some embodiments, the signaling element 181 may be entirely embedded inside the movable member 121, so that the signaling element 181 could be protected by the movable member 121. The sensing element 182 may be configured to operably couple to the lower wall 192 (e.g., a second side) of the first position limiting structure 185. In some embodiments, the sensing element 182 may be disposed in the lower wall 192 (e.g., a second side) of the first position limiting structure 185. For example, the sensing element 182 may be embedded in a recessed portion of the lower wall of the first position limiting structure 185. In some embodiments, a portion of the sensing element 182 may be exposed. In some embodiments, the entire sensing element 182 may be disposed below the lower wall of the first position limiting structure 185, so that the sensing element 182 could be protected by the lower wall of the first position limiting structure 185. The lower wall of the first position limiting structure 185 is the wall along which the movable member 121 slides.

In some embodiments, the sensing element 182 may be disposed at the upper wall of the first position limiting structure 185. Correspondingly, the signaling element 181 may be disposed at the upper surface of the movable member 121 to face the upper wall where the sensing element 182 is disposed. In some embodiments, the locations of the signaling element 181 and the sensing element 182 may be switched. For example, the signaling element 181 may be disposed at the lower wall (or the upper wall) of the first position limiting structure 185, and the sensing element 182 may be disposed at the lower surface (or the upper surface) of the movable member 121. When the sensing element 182 is disposed either at the lower surface or the upper surface of the movable member 121, the movable member 121 may include a power source electrically connected with the sensing element to provide electric power to the sensing element 182. The decoupling between the induction element and the movable member element makes it possible to replace either of the above in the event of a failure.

In the embodiments in which the signaling element 181 is disposed on the movable member 121, or the sensing element 182 is disposed on the movable member 121, the relative position or distance between the signaling element 181 and the sensing element 182 may change as the movable member 121 moves. For example, when the handle 110 is lifted up by the operator, the movable member 121 is moved to the right toward the right end wall of the first position limiting structure 185. The movement of the movable member 121 may cause the signaling element 181 to move from left to right (if the signaling element 181 is mounted on the movable member 121). Depending on the original location of the signaling element 181, when the movable member 121 moves from left to right (to compress the restoration member 141), the signaling element 181 may move from a location to the left of the sensing element 182, to a location right above the sensing element 182, and to a location to the right of the sensing element 182.

In the state shown in FIG. 4, when the movable member 121 abuts against the top portion of the mounting bracket 151, the signaling element 181 may be located to the left of the sensing element 182. When the power supply 100 is inserted further downwardly, and the tip portion of the movable member 121 slides downwardly along the surface of the mounting bracket 151, the movable member 121 may be pushed by the mounting bracket 151 to move into the space of the first position limiting structure 185, causing the signaling element 181 to move to the right, closer to the sensing element 182. The signaling element 181 may move to a location right above the sensing element 182, and may move further to a location at the right side of the sensing element 182. When the tip portion of the movable member 121 engages with (e.g., enter into or is received within) the recessed portion of the second position limiting structure 210, the movable member 121 may move to the left direction, causing the signaling element 181 to move from a location to the right of the sensing element 182, to a location right above the sensing element 182. When the tip portion of the movable member 121 is fully inserted into the recessed portion of the mounting bracket 151, the location of the signaling element 181 may correspond to or be aligned with the location of the sensing element 182 (e.g., the location of the signaling element 181 may be right above the location of the sensing element 182). In some embodiments, at this state, the signaling element 181 may face the sensing element 182. At this position, the movable member 121 may be located at a predetermined location with respect to the first position limiting structure 185.

The signaling element 181 may generate a sensing signal, which may be detected by the sensing element 182 when the relative positions between the signaling element 181 and the sensing element 182 are close to one another (e.g., when the distance between the signaling element 181 and the sensing element 182 is shorter than a predetermined distance such that the sensing element 182 can detect the sensing signal generated by the signaling element 181). As the signaling element 181 and the sensing element 182 move closer to one another, the sensing signal detected by the sensing element 182 may become stronger. When the location of the signaling element 181 corresponds to or is aligned with the location of the sensing element 182, i.e., when the signaling element 181 is located right over the sensing element 182, the sensing signal detected by the sensing element 182 may become the strongest. At these locations, the sensing signal detected by the sensing element 182 may have a strength that satisfies a condition. The condition maybe a predetermined condition (e.g., is greater than or equal to a predetermined strength value). When the strength of the sensing signal detected by the sensing element 182 satisfies the predetermined condition (e.g., is greater than or equal to the predetermined strength value), the sensing element 182 may generate an indication signal indicating that the left side of the power supply 100 has been mounted to the predetermined mounting position (e.g., with the tip portion of the movable member 121 inserted into the recessed portion of the mounting bracket 151) at the battery compartment 150 defined by the mounting brackets 151 and 152. When the strength of the sensing signal detected by the sensing element 182 does not satisfy the predetermined condition (e.g.., is smaller than the predetermined strength value), the sensing element 182 may generate an indication signal indicating that the left side of the power supply 100 has not been mounted to the predetermined mounting position.

Using the magnet (or alternatively, an electric coil) as an example of the signaling element 181, and a Hall effect sensor as an example of the sensing element 182, the interaction between the signaling element 181 and the sensing element 182 is explained below. When the movable member 121 is moved from left to right into the first position limiting structure 185, the magnet fixed on the movable member 121 moves closer to the Hall effect sensor as the movable member 121 is moved. The magnetic flux intensity (an example of the sensing signal) of the magnetic field detected by the Hall effect sensor may increase. When the location of the magnet corresponds to the location of the Hall effect sensor (e.g., when the magnet is closest to the Hall effect sensor), the magnetic flux intensity detected by the Hall effect sensor may be the largest, which may be greater than or equal to a predetermined magnetic flux intensity BH. At this state, the movable member 121 is moved to a predetermined location in the first position limiting structure 185, a location where the signaling element is located right over the sensing element, or the distance between the signaling element and the sensing element is the shortest. As a result, the Hall effect sensor may generate a first indication signal indicating that the left side of the power supply 100 has been mounted at the predetermined mounting position. When the magnet moves away from the Hall effect sensor, the magnetic flux intensity measured by the Hall effect sensor may decrease. When the magnetic flux intensity detected by the Hall effect sensor becomes less than a predetermined magnetic flux intensity threshold BH, the Hall effect sensor may generate a second indication signal indicating that the left side of the power supply 100 has not been mounted to the predetermined mounting position. For example, when the tip portion of the movable member 121 has not been securely engaged with the recessed portion of the second position limiting structure 210, for example, when the tip portion is in the state shown in FIG. 4, the magnet may be located to the left of the Hall effect sensor. The magnetic flux intensity measured by the Hall effect sensor may be less than the predetermined magnetic flux intensity threshold BH. The Hall effect sensor, if activated (or powered on), may generate the second indication signal indicating that the left side of the power supply 100 has not been mounted to the predetermined mounting position. As another example, if the power supply 100 is lifted out of the mounting brackets 151 and 152, the movable member 121 may be moved by the handle 110 to the right toward the right wall of the first position limiting structure, and the magnet on the movable member 121 may be moved to a location that is on the right side of the Hall effect sensor. As a result, the magnetic flux intensity measured by the Hall effect sensor may be smaller than the predetermined magnetic flux intensity threshold BH. Thus, the Hall effect sensor may generate the second indication signal indicating that the left side of the power supply 100 is not (or has not been) mounted at the predetermined mounting position. Using the magnet (or alternatively, an electric coil) as an example of the signaling element 181, and a Hall effect sensor as an example of the sensing element 182, the non-contact position detection could be realized. The detecting device 170 could be durable, and achieve miniaturization and accurate detection.

As shown in FIG. 4, the power supply 100 may also include a controller 250. The controller 250 may include any suitable circuit, processor, gate, etc. The processor may be a central processing unit ("CPU"). The processor may include other hardware chips, such as an application-specific integrated circuit ("ASIC"), a programmable logic device ("PLD"), or a combination thereof. The PLD may be a complex programmable logic device ("CPLD"), a field-programmable gate array ("FPGA"), etc.

The controller 250 may be included inside the power supply 100, and may be electrically connected with the sensing element 182 through a wired or wireless communication. The controller 250 may receive an output signal of the sensing element 182 and may determine whether the power supply 100 has been mounted to the predetermined mounting position. In the embodiments where both sides of the power supply 100 include a detecting device, the controller 250 may be electrically connected with the sensing elements from both detecting devices, and may determine whether the power supply 100 has been mounted at the predetermined mounting position based on the signals received from both of the sensing elements.

FIG. 5 shows a cross-sectional view of the power supply 100 mounted to the battery compartment 150, with the tip portion of the movable member 121 being received in the second position limiting structure 210. As shown in FIG. 5, structures and components at the right side of the battery compartment 150 and the power supply 100 are similar with those shown on the left side. In some embodiments, the structures and components at the right side of the battery compartment 150 and the power supply 100 may be different from those shown on the left side.

In some embodiments, the power supply 100 may include a power button or switch on the body 105, e.g., on a top or side surface of the body 105. When the power button or switch is operated, the electric power provided by the at least one battery 115 to the sensing element 182 may be controlled. In some embodiments, during a mounting process, the power supply 100 may be lowered or inserted vertically into the battery compartment 150. Before the movable member 121 engages with the second position limiting structure 210, the power button or switch may not be activated, and electric power from the at least one battery 115 may not be supplied to the sensing element 182. Thus, the sensing element 182 may not generate a signal. After the movable member 121 engages with the second position limiting structure 210, the power button or switch may be activated or switched on. For example, the power button may be activated or connected/turned on under a triggering operation of the user, such that the electric power is supplied from the at least one battery 115 to the sensing element 182. At this state, the movable member 121 may be at a predetermined location in the first position limiting structure 185, and the sensing signal received by the sensing element 182 may have a strength that is greater than or equal to the predetermined strength value. In some embodiments, during the mounting process of the power supply 100, the power button may be maintained activated (e.g., be turned on and kept on during the process).

FIG. 6 shows a partial cross-sectional view of the upper left side of the power supply 100, as indicated by the dashed circle shown in FIG. 5. FIG. 6 illustrates that the tip portion of the movable member 121 is received in the recessed portion of the second position limiting structure 210. At this position, the signaling element 181 (e.g., a magnet) may be located right over or above the sensing element 182 (e.g., a Hall effect sensor), as shown in FIG. 6. Compared to the state shown in FIG. 4, in the state shown in FIG. 6, the movable member 121 is further pushed to the right. Thus, the signaling element 181 is moved closer to the sensing element 182. At the state shown in FIG. 6, the location of the signaling element 181 corresponds to or is aligned with the location of the sensing element 182. The location at which the movable member 121 is located may be referred to a predetermined location of the movable member 121 with respect to the first position limiting structure 185. At this state, the movable member 121 may provide a pressing force against the restoration member 141, hence the restoration member may be compressed. In turn, the restoration member 141 may provide a restoration force pressing the movable member 121 toward the mounting bracket 151, thereby securing the mounting of the power supply 100 at the left side. For example, when the restoration member 141 is a spring, the spring may be compressed by the movable member 121, and may in turn, provide a resilient force against the movable member 121, pushing the movable member 121 tightly against the second position limiting structure 210 of the mounting bracket 151. At this state, when the signaling element 181 is a magnet, the sensing element 182 is a Hall effect sensor, the magnetic flux intensity measured by the Hall effect sensor may be the largest, which may be greater than or equal to the predetermined magnetic flux intensity value BH. At this state, the Hall effect sensor may generate the first indication signal indicating that the left side of the power supply 100 has been mounted to the mounting position.

When the power supply 100 is detached from the battery compartment 150 that includes the mounting bracket 151, the handle 110 may be lifted up, causing the pin 131 to move to the right from the position shown in FIG. 6, which in turn drives the movable member 121 to slide to the right from the position shown in FIG. 6 to compress the restoration member 141. The second end (e.g., the right end) of the movable member 121 may be moved to a retracted position that is closer to right end wall 194 than the position of the second end shown in FIG. 6. At this retracted position, the signaling element 181 may be located to the right of the sensing element 182. The tip portion of the movable member 121 may retrieve from the recessed portion of the second position limiting structure 210, and separate from the second position limiting structure 210. Then the power supply 100 may be lifted further up and separated from the mounting brackets. When the power supply 100 is detached from the battery compartment 150, if the signaling element 181 is a magnet, the sensing element is a Hall effect sensor, the magnet may be located to the right of the Hall effect sensor. At this state, the magnetic flux intensity of the magnet measured or detected by the Hall effect sensor may be the largest, which may be smaller than the predetermined magnetic flux intensity value BH. Thus, the Hall effect sensor may generate the second indication signal indicating that the left side of the power supply 100 is not or has not been mounted to the predetermined mounting position.

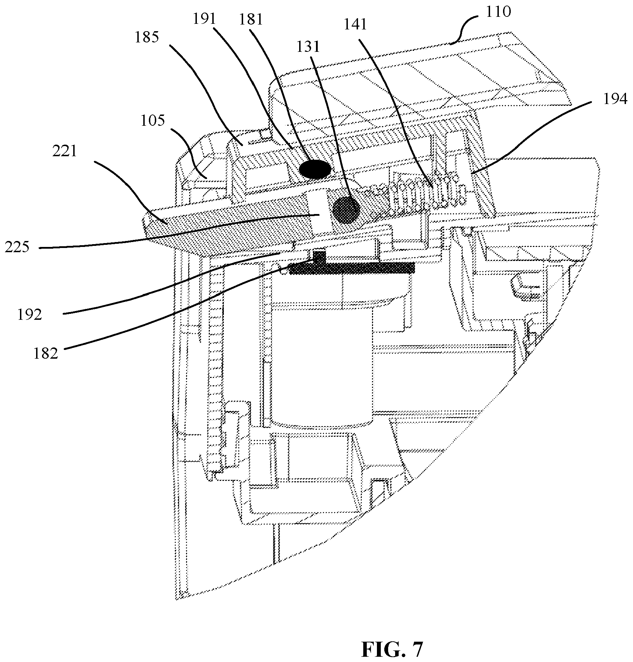

FIG. 7 is a cross-sectional view of a portion of the power supply 100, showing another embodiment of the detecting device disposed at the upper left side of the power supply 100. It is understood that in some embodiments, the right side of the power supply 100 may have similar structures, components, and configurations, the illustration and descriptions of which are omitted. In this embodiment, all other components and structures of the power supply 100 are similar to those shown in FIG. 3 to FIG. 6, except that the configurations of the movable member and the sensing assembly of the detecting device are different. As shown in FIG. 7, the detecting device may include a movable member 221. The movable member 221 may include a through hole 225 extending from an upper surface of the movable member 221 to a lower surface of the movable member 221. The sensing element 182 of the sensing assembly may be disposed at the lower wall 192 of the first position limiting structure 185, similar to the embodiment shown in FIG. 3 to FIG. 6. The signaling element 181 may be disposed at the upper wall 191 of the first position limiting structure 185, facing the upper surface of the movable member 221. The signaling element 181 and the sensing element 182 may be located at two sides (in the up and down vertical direction) of the movable member 221. It is understood that in some embodiments, the locations of the signaling element 181 and the sensing element 182 may be exchanged.

When the movable member 221 is moved along the space of the first position limiting structure 185, either due to the pulling of the handle 110, or due to the pushing of a mounting bracket (not shown in FIG. 7), or due to the restoration force of the restoration member 141, the relative positions between the signaling element 181 and the sensing element 182 remain unchanged. However, the relative positions between the signaling element 181 and the sensing element 182, and the through hole 225 may change. When the power supply 100 is not mounted to the predetermined mounting position, the through hole 225 is not aligned with the signaling element 181 and the sensing element 182. Then the sensing signal generated by the signaling element 181 may be blocked by the movable member 221, such that the strength of the sensing signal detected by the sensing element 182 may be weak (e.g., smaller than a predetermined strength value) or zero. The sensing element 182 may generate the second indication signal indicating that the power supply 100 has not been mounted to the predetermined mounting position. When the power supply 100 is mounted to the predetermined mounting position, the through hole 225 is aligned with the signaling element 181 and the sensing element 182. Then the sensing signal generated by the signaling element 181 may pass through the through hole 225 and be received by the sensing element 182, such that the strength of the sensing signal detected by the sensing element 182 may be greater than or equal to the predetermined strength value. The sensing element 182 may generate the first indication signal indicating that the power supply 100 has been mounted to the predetermined mounting position.

For example, when the signaling element 181 is a magnet (or electric coil), the sensing element 182 is a Hall effect sensor, the magnetic flux intensity detected by the Hall effect sensor may be smaller than the predetermined magnetic flux intensity value BH when the through hole 225 is not aligned with the magnet and the Hall effect sensor due to the power supply 100 not being mounted at the predetermined mounting position. As a result, the Hall effect sensor may generate the second indication signal indicating that the left side of the power supply 100 has not been mounted to the predetermined mounting position. When the power supply 100 is securely mounted to the mounting bracket 151, for example, when the tip portion of the movable member 221 is received by a recessed portion of a second position limiting structure (similar to the second position limiting structure 210 shown in FIG. 6), the through hole 225 may be aligned with the magnet and the Hall effect sensor. As a result, the magnetic flux intensity measured or detected by the Hall effect sensor may be greater than the predetermined magnetic flux intensity value BH. The Hall effect sensor may generate the first indication signal indicating that the left side of the power supply 100 has been mounted to the predetermined mounting position. In some embodiments, depending on the material of the movable member 121, when the through hole 225 is not aligned with the magnet and the Hall effect sensor, the Hall effect sensor may not detect any magnetic flux of the magnet, and may generate the second indication signal. When the through hole 225 is aligned with the magnet and the Hall effect sensor, the Hall effect sensor may detect the magnetic flux, and may generate the first indication signal.

As discussed above, the detection device may use any suitable non-contact, wireless sensing manner. For example, in the examples of magnet and Hall effect sensor, the magnetic field is used. In the embodiment shown in FIG. 7, optical and/or acoustic fields may be used. For example, the signaling element 181 may be a light emitter of an optocoupler, which may be configured to generate a light beam (an example of the sensing signal), and the sensing element 182 may be a light receiver of the optocoupler, which may be configured to receive the light beam when the through hole 225 is aligned with the signaling element 181 and the sensing element 182 and generate an electric signal. The light receiver may generate a first electric signal (e.g., the first indication signal) when the light beam is received to indicate that the power supply 100 has been mounted to the predetermined mounting position. When the power supply 100 is not mounted to the predetermined mounting position, the through hole 225 may not be aligned with the light emitter and the light receiver, and the light beam may be blocked by the movable member 221. As a result, the light receiver may not receive the light beam, and may generate a second electric signal (e.g., the second indication signal) indicating that the power supply 100 has not been mounted to the predetermined mounting position. In some embodiments, the first electric signal and the second electric signal may be voltage signals.

In some embodiments, the signaling element 181 may be an acoustic transducer configured to generate a sound wave. The sensing element 182 may be an acoustic receiver configured to receive the sound wave and generate an electric signal. When the through hole 225 is aligned with the acoustic transducer and the acoustic receiver, the sound wave generated by the acoustic transducer may be received by the acoustic receiver, and the amplitude of the received sound wave may be greater than or equal to a predetermined amplitude. The acoustic receiver may generate an electric signal (e.g., a first indication signal) indicating that the power supply 100 has been mounted to the predetermined mounting position.

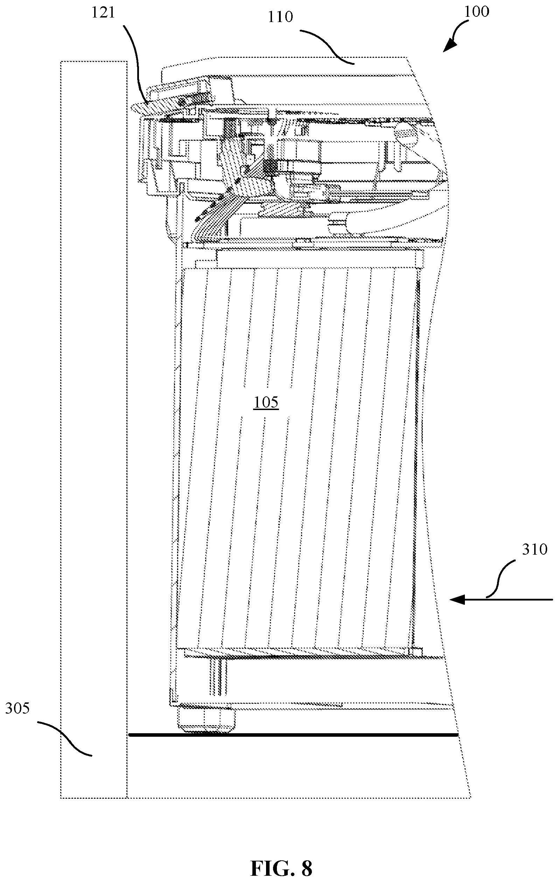

FIG. 8 is a cross-sectional view of a part of the power supply 100 and a portion of a battery compartment 305. In the embodiments shown in FIG. 3 to FIG. 7, the power supply 100 is vertically mounted to a battery compartment 150. The power supply 100 may also be mounted horizontally to a battery compartment. The power supply 100 may be slid into or onto the battery compartment 305 as indicated by the arrow 310. The power supply 100 may include a detecting device that may be any embodiment described in the present disclosure. The detecting device may include the movable member 121 (or the movable member 221), the restoration member 141, the sensing assembly 180. The sensing assembly 180 may include the signaling element 181 and the sensing element 182. Although the movable member 121 is shown as an example, it is understood that the movable member may be movable member 221. When the power supply 100 is slid from right to the left toward a vertical wall of the battery compartment 305, the movable member 121 may be pushed into the space of the first position limiting structure 185 when the movable member 121 abuts against the vertical wall of the battery compartment 305. As the power supply 100 is pushed further to the left against the vertical wall of the battery compartment 305, the movable member 121 may be pushed further into the space of the first position limiting structure 185.

When the power supply 100 is pushed to a predetermined mounting position, the movable member 121 may be pushed into a predetermined location in the space of the first position limiting structure 185, where the location of the signaling element 181 may correspond to or be aligned with the location of the sensing element 182 (e.g., the signaling element 181 may be at a position that is closest to the sensing element 182), or that the through hole 225 may be aligned with the signaling element 181 and the sensing element 182. At this state, the sensing signal detected by the sensing element 182 may be greater than or equal to a predetermined signal strength (e.g., in the embodiment of a magnet and a Hall effect sensor, the magnetic flux intensity detected by the Hall effect sensor may be greater than or equal to the predetermined magnetic flux intensity value BH). The sensing element 182 may generate the first indication signal indicating that the power supply 100 has been mounted to the predetermined mounting position. If the power supply 100 has not been pushed to the predetermined mounting position, and the movable member 121 has not been moved to the predetermined location within the space of the first position limiting structure 185, the sensing signal detected by the sensing element 182 may not be sufficiently strong (e.g., in the embodiment of the magnet and the Hall effect sensor, the magnetic flux intensity detected by the Hall effect sensor may be smaller than the predetermined magnetic flux intensity value BH), and the sensing element 182 may generate the second indication signal indicating that the power supply 100 has not been mounted to the predetermined mounting position. Using the indication signal to indicate the state, such as the mounting state of the power supply 100, may improve the response time, and is convenient for users to obtain the installation status of the power supply 100.

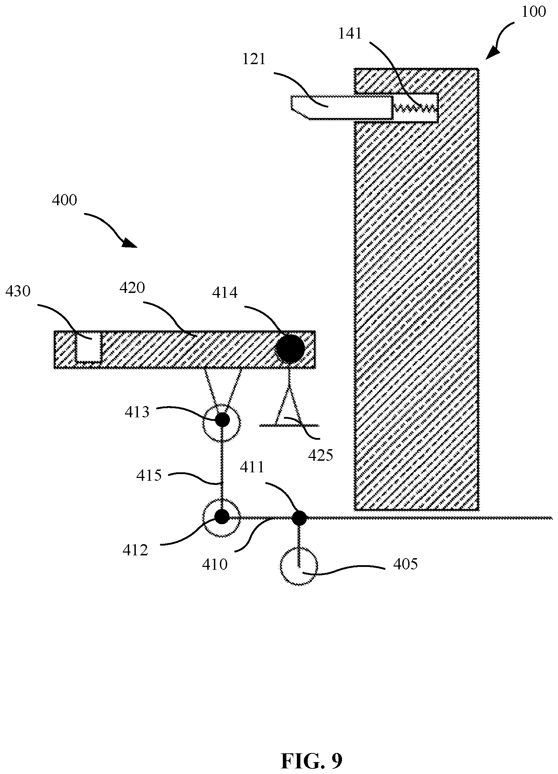

FIG. 9 is a schematic illustration of the power supply 100 and a horizontal battery compartment 400. The horizontal battery compartment 400 may include a base 405. A horizontal mounting plate 410 may be horizontally disposed on the base 405 through a first pivotal connection 411. Thus, the horizontal mounting plate 410 may pivot relative to the base 405 through the first pivotal connection 411. The first pivotal connection 411 may include a pin or any other suitable pivoting connection elements. An end of the horizontal mounting plate 410 may be pivotally connected with a vertical movable member 415 through a second pivotal connection 412. The second pivotal connection 412 is not fixed, and may be movable up and down. The vertical movable member 415 may be pivotally connected with a vertical mounting plate 420 through a third pivotal connection 413. The third pivotal connection 413 is not fixed, and may be movable up and down. The vertical mounting plate 420 may be pivotally connected with a fixed base 425 through a fixed, fourth pivotal connection 414. When the power supply 100 is slid onto the horizontal mounting plate 410, the weight of the power supply 100 may push the right half of the horizontal mounting plate 410 downwardly, causing the left half, including the second pivotal connection 412, of the horizontal mounting plate 410 to rise. The rise of the second pivotal connection 412 pushes the vertical movable member 415 upward. The upward movement of the vertical movable member 415 may cause the vertical mounting plate 420 to pivotally rotate around the fixed fourth pivotal connection 414. Thus, the vertical mounting plate 420 may rotate clockwise until it reaches a vertical position. At this position, the power supply 100 may be pushed from right to left to abut against the vertical mounting plate 420. The movable member 121 (or 221) of the power supply 100 may be received in a recessed portion 430 provided on the vertical mounting plate 420. The recessed portion 430 may be a snap-fit hole.

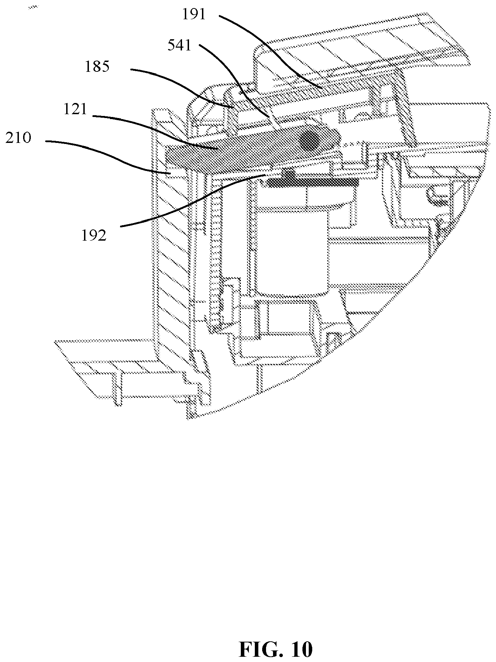

FIG. 10 is a cross-sectional view of a portion of the power supply 100, showing another embodiment of the configuration of the movable member and the restoration member. As shown in FIG. 10, a restoration member 541 may be connected with a top surface of the movable member 121 and the top wall 191 of the first position limiting structure 185, rather than being connected to the right end of the movable member 121. The restoration member 541 may be any suitable flexible or resilient structure, such as a spring, a flexible rubber piece, a flexible plate, etc. Although the restoration member 541 is shown as being disposed between the upper wall 191 and the top surface of the movable member 121, the restoration member 541 may be disposed at other suitable locations. For example, the restoration member 541 may be connected with the lower wall 192 and the lower surface of the movable member 121. When the tip portion of the movable member 121 slides along the mounting bracket 151 until the tip portion of the movable member 121 engages with the second position limiting structure 210, under the restoration force of the restoration member 541, the movable member 121 extends into the recessed portion (e.g., space) of the second position limiting structure 210, thereby improving the stability and safety of the power supply 100 during operation. The configuration of the restoration member 541 may also be applied to other embodiments, such as the embodiments shown in FIG. 7 to FIG. 9.

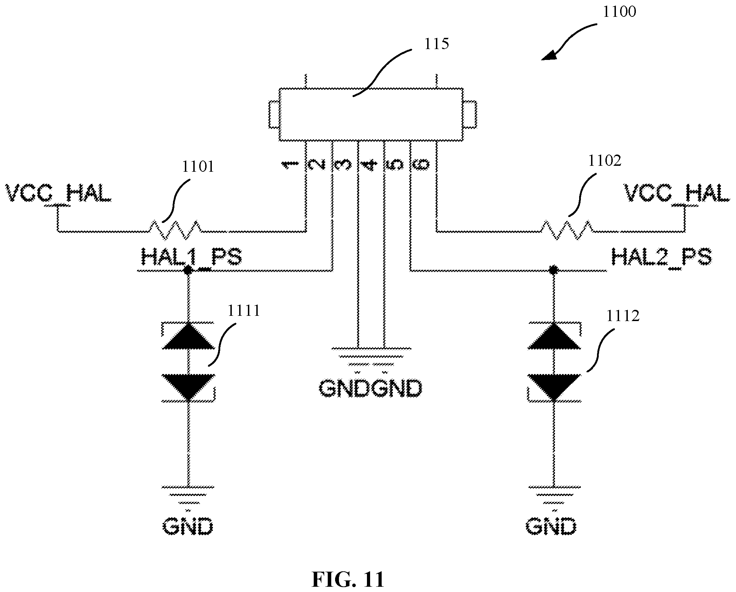

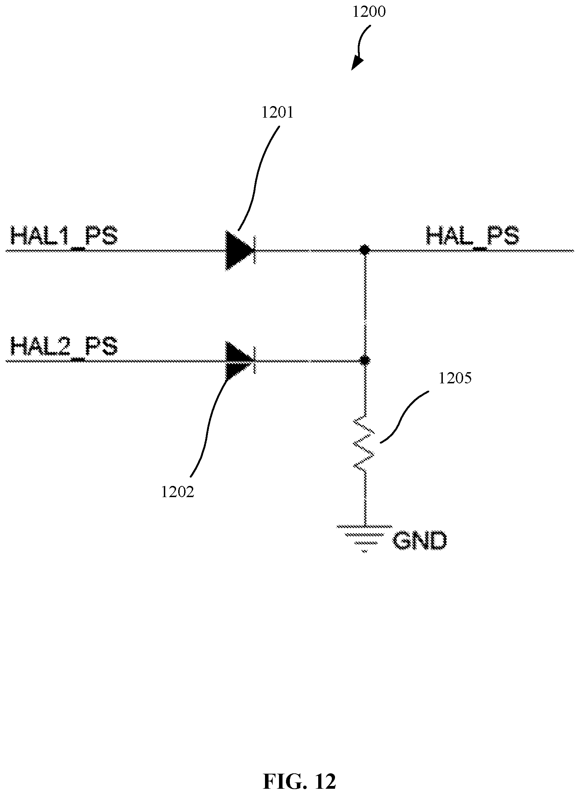

FIG. 11 and FIG. 12 are example circuits connected with the sensing element 182 (e.g., the Hall effect sensor) for determining whether the power supply 100 has been mounted to the predetermined mounting position. These circuits may be included in the controller 250 shown in FIG. 4. Here, it is assumed that the power supply 100 includes two detecting devices disposed at both the left side and the right side of the power supply 100, for example, adjacent the left end and the right end of the handle 110. The detecting devices may be identical or may be different. Depending on the mounting position of the power supply 100, such that the relative positions between the signaling element 181 and the sensing element 182, the two detecting devices may generate two indication signals (either the first indication signal indicating that a side of the power supply 100 has been mounted to the desired mounting position, or the second indication signal indicating that a side of the power supply 100 has not been mounted to the desired mounting position). The two signals may be fed into a circuit 1100 shown in FIG. 11 as indicated by HAL1_PS and HAL2_PS. In the circuit 1100, battery 115 provides power to the sensing elements 182 as indicated by VCC_HAL. Elements 1101 and 1102 are resistors of a suitable resistance value. Elements 1111 and 1112 are diodes that protect the rest of the circuits from static electricity. The voltages represented by HAL1_PS and HAL2_PS are supplied to a circuit 1200 shown in FIG. 12. It is understood that the circuit 1200 shown in FIG. 12 is a portion of the circuit 1100, but is separately shown only for illustrative purposes. The voltages represented by HAL1_PS and HAL2_PS are applied to diodes 1201 and 1202 respectively in a parallel manner. That is, two sensing elements 182 may be electrically connected in parallel to provide the voltages at HAL1_PS and HAL2_PS. It is understood that the present disclosure is not limited to two detecting devices 170. More than two detecting devices 170 (hence more than two pairs of signaling element 181 and sensing element 182) may be included, and the circuits shown in FIG. 11 and FIG. 12 may be correspondingly expanded. The circuit 1200 may function as a logic OR gate. For example, when both voltages at HAL1_PS and HAL2_PS (examples of a fourth signal and a fifth signal) are low voltages (e.g., both being lower than a predetermined voltage value), the output HAL_PS (an example of a third indication signal) of the circuit 1200 is a predetermined low voltage (e.g., 0V, 0.5V, etc.) The predetermined low voltage may be specified based on actual needs and configurations. When any one of the voltages at HAL1_PS and HAL2_PS is a high voltage (e.g., higher than the predetermined voltage value), the output HAL_PS may be a predetermined high voltage (e.g., 1V, 3V, 5V, etc.). The predetermined high voltage may be specified based on actual needs and configurations. Thus, the signal HAL_PS is a based on the combination of signals HAL1_PS and HAL2_PS. In FIG. 12, element 1205 is a resistor having a suitable resistance value. In some embodiments, a logic AND gate or other types of gates may be used in place of or in addition to the OR gate. An AND gate typically includes two or more inputs, such as voltage signals. Only when all of the inputs are at a high voltage (corresponds to a binary digit number 1), the output of the AND gate is a high voltage (or binary digit number 1); otherwise, the output of the AND gate is a low voltage (or binary digit number 0). For example, when all of the inputs (which may be connected with the sensing elements included in the sensing devices of the power supply) are high voltages, the output of the AND gate is a high voltage, indicating that the power supply is mounted at the predetermined mounting position. Otherwise, when the output of the AND gate is a low voltage, it may indicate that the power supply is not mounted at the predetermined mounting position.

For example, using the embodiment shown in FIG. 3 as an example, when either one side of the power supply 100 has been mounted to the predetermined mounting position at the mounting bracket 151 or 152, the sensing element 182 at the corresponding side may generate a low voltage. Otherwise, when either one side of the power supply 100 has not been mounted to the predetermined mounting position at the mounting bracket 151 or 152, the sensing element 182 at the corresponding side may generate a high voltage (an example of the second indication signal). When both voltages at HAL1_PS and HAL2_PS are low voltage signals, the output HAL_PS is a low voltage (e.g., lower than a predetermined low voltage value). The low voltage signal at HAL_PS (an example of a third indication signal) may indicate that the power supply 100 has been mounted to the predetermined mounting position at both sides. When one of the voltages at HAL1_PS and HAL2_PS is a high voltage signal, the output HAL_PS is a high voltage (e.g., higher than a predetermined high voltage value). The high voltage signal at HAL_PS (an example of a fourth indication signal) may indicate that at least one side of the power supply 100 has not been properly mounted to the predetermined mounting position. By setting up at least two detection devices, the level jump caused by the magnetic field interference of a single Hall sensor is avoided, so that the anti-interference ability of the detection devices is stronger, and the misjudgment of the power supply 100 mounted to the predetermined mounting position caused by this situation is avoided. Thus the output HAL_PS is more accurate.

In some embodiments, upon detecting that the power supply 100 is not properly mounted to the predetermined mounting position, either on one side or on both sides, a suitable message may be generated by the power supply 100 to alert an operator. Such a message may include an audio message (e.g., a beep or an alerting message), a video message (e.g., a short video displayed on a display of the movable platform), a text message (e.g., a warning message displayed on a display of the movable platform, or a display on the power supply 100), or a combination thereof.

Although in the example embodiments described above, the power supply 100 is assumed to have a detecting device at both sides (left and right), it is understood that in some embodiments, only one side may be provided with a detecting device. The detecting device, which may include the movable member 121, the signaling element 181, the sensing element 182, the restoration member 141, may generate the first indication signal when the power supply 100 is mounted to the predetermined mounting position, or the second indication signal when the power supply 100 is not mounted to the predetermined mounting position. Based on the indication signal generated by the single detecting device, the operator may be alerted as to whether the power supply 100 has been mounted to the predetermined mounting position.

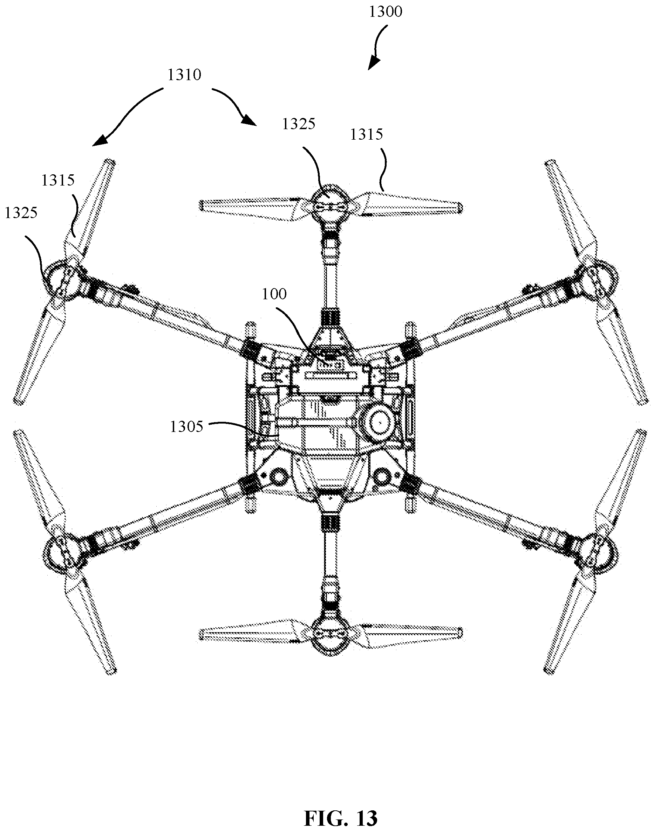

FIG. 13 is a top view of a movable platform 1300 in which the power supply 100 can be used. A UAV is shown in FIG. 13 as an example of the movable platform 1300. The movable platform 1300 may include a machine body 1305 having a battery compartment (e.g., 150 shown in FIG. 3), with which the power supply 100 may be operably coupled. The movable platform 1300 may include a propulsion system 1310 configured to provide a propulsion for the movement of the movable platform 1300. In some embodiments, the propulsion system 1310 may include at least one propeller and at least one rotor. For example, the propulsion system 1310 may include a plurality of propellers 1315 and a plurality of motors 1325. The motors 1325 may be configured to drive the propellers 1315 to rotate.

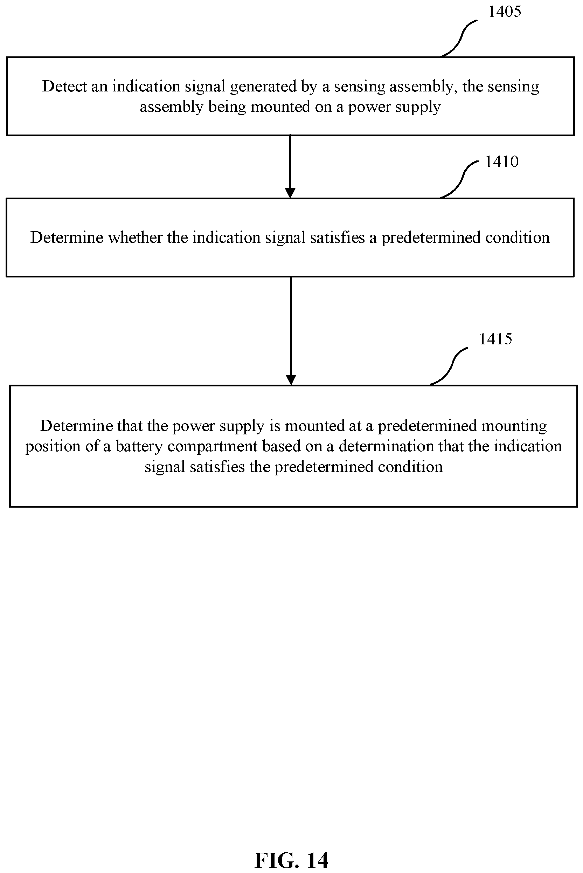

FIG. 14 is a flow chart illustrating a method for detecting whether a power supply has been mounted to a predetermined mounting position. The method shown in FIG. 14 may include detecting an indication signal generated by a sensing assembly, the sensing assembly being mounted on a power supply (step 1405). The indication signal may include at least one of a first indication signal for indicating that the power supply is mounted at the predetermined mounting position of the battery compartment, and a second indication signal for indicating that the power supply is not mounted at the predetermined mounting position of the battery compartment. The method may also include determining whether the indication signal satisfies a predetermined condition (step 1410). The method may further include determining that the power supply is mounted at a predetermined mounting position of a battery compartment based on a determination that the indication signal satisfies the predetermined condition (step 1415).

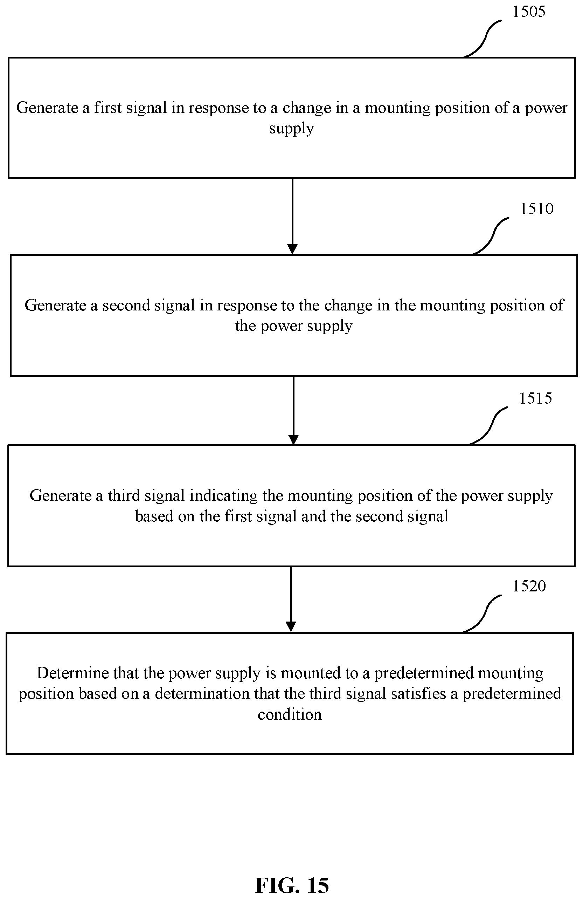

FIG. 15 is a flow chart illustrating a method for detecting whether a power supply has been mounted to a predetermined mounting position. The method shown in FIG. 15 may include generating a first signal in response to a change in a mounting position of a power supply (step 1505). The method may also include generating a second signal in response to the change in the mounting position of the power supply (step 1510). The method may also include generating a third signal indicating the mounting position of the power supply based on the first signal and the second signal (step 1515). The method may further include determining that the power supply is mounted to a predetermined mounting position based on a determination that the third signal satisfies a predetermined condition (step 1520).

A person having ordinary skill can appreciate that all or some of the steps of the disclosed methods may be implemented through hardware that implements the computer program code. The computer program code may be stored in a non-transitory computer-readable storage medium. When the computer program code is executed, the steps of the disclosed methods may be performed. The non-transitory computer-readable storage medium can be any medium that can store program codes, for example, a magnetic disk, an optical disk, a read-only memory ("ROM"), and a random-access memory ("RAM"), etc.

The technical solutions of the present disclosure for determining whether the power supply has been mounted to a predetermined mounting position are not limited to the embodiments described above. For example, in some embodiments, the digital switch-type Hall effect sensor may be replaced by a linear Hall effect sensor. An ADC (analog-to-digital) converter of a single chip computer may acquire the output voltage of the linear Hall effect sensor and determine whether the detected magnetic flux intensity is higher than, equal to, or lower than the predetermined magnetic flux intensity value to determine whether the power supply is mounted to the predetermined mounting position.

In some embodiments, the Hall effect sensor may be replaced by an imaging sensor (e.g., a camera, etc.). Computer vision and machine learning technologies may be used to recognize a predetermined image pattern to determine whether the power supply has been mounted to the predetermined mounting position.

In some embodiments, the Hall effect sensor may be replaced by an optoelectrical sensor. The optoelectrical sensor may be coupled with a predetermined light sensing medium. The optoelectrical sensor may be mounted on the power supply. The light sensing medium may be provided at the predetermined mounting position on the movable platform, such as the UAV, through various methods, such as coating, pasting, etc. According to a time difference between the optoelectrical sensor transmitting and receiving a light beam, a determination may be made as to whether the light beam passes through the predetermined light sensing medium, which may indicate whether the power supply has been mounted to the predetermined mounting position.

In some embodiments, the Hall effect sensor may be replaced by an ultrasonic wave sensor, a pressure sensor, a temperature sensor, a gas sensor, a sound wave sensor, a laser sensor, etc.

While embodiments of the present disclosure have been shown and described herein, it will be obvious to those skilled in the art that such embodiments are provided by way of example only. Numerous variations, changes, and substitutions will now occur to those skilled in the art without departing from the present disclosure. It should be understood that various alternatives to the embodiments of the invention described herein and as defined in the appended claims may be employed in practicing the present disclosure.

## Claims

1. A power supply (100), comprising:
at least one battery ;
a shell (106) configured to house the at least one battery; and
at least one detecting device (170) configured to operably couple to the shell (106) and comprising
a movable member (121, 122),
a sensing assembly (180), and
a first position limiting structure (185),
wherein the movable member (121, 122) is configured to movably couple with a first side of the position limiting structure,
wherein the sensing assembly (180) is configured to generate an indication signal for indicating whether the power supply (100) has been mounted to at a mounting position of a battery compartment (150) based on a location of the movable member (121, 122),
wherein the movable member (121, 122) is configured to move according to a position of the power supply (100), such that the sensing assembly (180) generates the indication signal for indicating whether the power supply (100) has been mounted at the mounting position of the battery compartment (150) based on a location of the movable member (121, 122), and
wherein a first side of the movable member (121, 122) is configured to movably connect with the first side of the first position limiting structure (185) and a second side of the movable member (121, 122) is configured to extend out of the shell (106) when the power supply (100) is mounted at the mounting position of the battery compartment (150).

2. The power supply (100) of claim 1, wherein the indication signal comprises a first indication signal for indicating that the power supply (100) is mounted at the mounting position.

3. The power supply (100) of claim 1, wherein when the power supply (100) is mounted at the mounting position, the movable member (121, 122) is moved to a location adjacent the first side of the first position limiting structure (185), the sensing assembly (180) generates a first indication signal for indicating that the power supply (100) is mounted at the mounting position.

4. The power supply (100) of claim 2, wherein the indication signal further comprises a second indication signal for indicating that the power supply (100) is not mounted at the mounting position, preferably
when the power supply (100) is not mounted at the battery compartment (150), the movable member (121, 122) is not located at the location adjacent the first side of the first position limiting structure (185), and the sensing assembly (180) generates the second indication signal for indicating that the power supply (100) is not mounted at the mounting position.

5. The power supply (100) of claim 1, further comprising a restoration member (141, 142) configured to provide a restoration force to the movable member (121, 122),

6. The power supply (100) of claim 5, wherein two ends of the restoration member are connected with the first side of the first position limiting structure (185) and the movable member (121, 122) respectively, or
wherein when the power supply (100) is mounted at the mounting position, the movable member (121, 122) is moved to the location adjacent the first side of the first position limiting structure (185) under the restoration force of the restoration member, or
wherein the restoration member is configured to be compressed under a force from the movable member (121, 122), or
wherein the restoration member is an elastic member, or
wherein the restoration member is at least partially disposed in the first position limiting structure (185).

7. The power supply (100) of claim 1,
wherein the sensing assembly (180) comprises a signaling element (181) and a sensing element (182), and
wherein the signaling element is configured to generate a sensing signal, and the sensing element is configured to generate a first indication signal for indicating that the power supply (100) is mounted at the mounting position of the battery compartment (150) based on the sensing signal.

8. The power supply (100) of claim 1, wherein the sensing assembly (180) comprises a non-contact sensing assembly (180).

9. The power supply (100) of claim 4, wherein the first indication signal is a low-voltage signal having a voltage lower than a voltage value, and the second indication signal is a high-voltage signal having a voltage higher than or equal to the voltage value.

10. The power supply (100) of claim 1, wherein when the power supply (100) is mounted at the mounting position of the battery compartment (150), at least a portion of the movable member (121, 122) is received in the first position limiting structure (185).

11. The power supply (100) of claim 1, wherein when the power supply (100) is mounted at the mounting position of the battery compartment (150), the movable member (121, 122) is coupled with a second position limiting structure of a mounting bracket.

12. The power supply (100) of claim 1, wherein while the power supply (100) is being mounted to the mounting position of the battery compartment (150), the movable member (121, 122) is configured to abut against a first side of the battery compartment (150) and is pressed to move toward the first side of the first position limiting structure (185) under a pressing force from the first side of the battery compartment (150).

13. A method for determining that the power supply (100) according to anyone of claims 1-12 is mounted at a predetermined mounting position of the battery compartment (150), the method comprising:
detecting an indication signal generated by a sensing assembly (180) when a first side of the movable member (121, 122) connects with the first side of the first position limiting structure (185) and a second side of the movable member (121, 122) extends out of the shell (106) when the power supply (100) is mounted at the mounting position of the battery compartment (150);
determining whether the indication signal satisfies a predetermined condition; and
determining that the power supply (100) is mounted at the predetermined mounting position of the battery compartment (150) based on a determination that the indication signal satisfies the predetermined condition.

14. A movable platform, comprising:
a power supply (100); and
a body comprising a battery compartment (150) for mounting the power supply (100),
wherein the power supply (100) is a power supply (100) according to any of claims 1-12.

## Patentansprüche

1. Stromversorgung (100), die Folgendes umfasst:
mindestens eine Batterie;
ein Gehäuse (106), das dazu ausgelegt ist, die mindestens eine Batterie unterzubringen; und
mindestens eine Detektionsvorrichtung (170), die dazu ausgelegt ist, an das Gehäuse (106) wirkgekoppelt zu sein, und Folgendes umfasst
ein bewegbares Element (121, 122),
eine Erfassungsanordnung (180), und
eine erste Positionsbegrenzungsstruktur (185),
wobei das bewegbare Element (121, 122) dazu ausgelegt ist, bewegbar an eine erste Seite der Positionsbegrenzungsstruktur gekoppelt zu sein,
wobei die Erfassungsanordnung (180) dazu ausgelegt ist, zum Anzeigen, ob die Stromversorgung (100) an einer Montageposition eines Batteriefachs (150) montiert wurde, auf Basis eines Ortes des bewegbaren Elements (121, 122) ein Anzeigesignal zu erzeugen,
wobei das bewegbare Element (121, 122) dazu ausgelegt ist, sich gemäß einer Position der Stromversorgung (100) zu bewegen, derart, dass die Erfassungsanordnung (180) zum Anzeigen, ob die Stromversorgung (100) an der Montageposition des Batteriefachs (150) montiert wurde, auf Basis eines Ortes des bewegbaren Elements (121, 122) das Anzeigesignal erzeugt, und
wobei eine erste Seite des bewegbaren Elements (121, 122) dazu ausgelegt ist, sich mit der ersten Seite der ersten Positionsbegrenzungsstruktur (185) bewegbar zu verbinden, und eine zweite Seite des bewegbaren Elements (121, 122) dazu ausgelegt ist, sich aus dem Gehäuse (106) zu erstrecken, wenn die Stromversorgung (100) an der Montageposition des Batteriefachs (150) montiert ist.

2. Stromversorgung (100) nach Anspruch 1, wobei das Anzeigesignal zum Anzeigen, dass die Stromversorgung (100) an der Montageposition montiert ist, ein erstes Anzeigesignal umfasst.

3. Stromversorgung (100) nach Anspruch 1, wobei, wenn die Stromversorgung (100) an der Montageposition montiert ist, das bewegbare Element (121, 122) zu einem Ort neben der ersten Seite der Positionsbegrenzungsstruktur (185) bewegt wird, die Erfassungsanordnung (180) zum Anzeigen, dass die Stromversorgung (100) an der Montageposition montiert ist, ein erstes Anzeigesignal erzeugt.

4. Stromversorgung (100) nach Anspruch 2, wobei das Anzeigesignal zum Anzeigen, dass die Stromversorgung (100) nicht an der Montageposition montiert ist, ferner ein zweites Anzeigesignal umfasst, vorzugsweise
wenn die Stromversorgung (100) nicht am Batteriefach (150) montiert ist, befindet sich das bewegbare Element (121, 122) nicht an dem Ort neben der ersten Seite der ersten Positionsbegrenzungsstruktur (185) und die Erfassungsanordnung (180) erzeugt zum Anzeigen, dass die Stromversorgung (100) nicht an der Montageposition montiert ist, das zweite Anzeigesignal.

5. Stromversorgung (100) nach Anspruch 1, die ferner ein Wiederherstellungselement (141, 142) umfasst, das dazu ausgelegt ist, eine Wiederherstellungskraft auf das bewegbare Element (121, 122) auszuüben.

6. Stromversorgung (100) nach Anspruch 5, wobei zwei Enden des Wiederherstellungselements mit der ersten Seite der ersten Positionsbegrenzungsstruktur (185) bzw. des bewegbaren Elements (121, 122) verbunden sind, oder
wobei, wenn die Stromversorgung (100) an der Montageposition montiert ist, das bewegbare Element (121, 122) unter der Wiederherstellungskraft des Wiederherstellungselements zu dem Ort neben der ersten Seite der Positionsbegrenzungsstruktur (185) bewegt wird, oder
wobei das Wiederherstellungselement dazu ausgelegt ist, unter einer Kraft vom bewegbaren Element (121, 122) zusammengedrückt zu werden, oder
wobei das Wiederherstellungselement ein elastisches Element ist, oder
wobei das Wiederherstellungselement mindestens teilweise in der ersten Positionsbegrenzungsstruktur (185) angeordnet ist.

7. Stromversorgung (100) nach Anspruch 1,
wobei die Erfassungsanordnung (180) eine Signalisierungskomponente (181) und eine Erfassungskomponente (182) umfasst, und
wobei die Signalisierungskomponente dazu ausgelegt ist, ein Erfassungssignal zu erzeugen, und die Erfassungskomponente dazu ausgelegt ist, zum Anzeigen, dass die Stromversorgung (100) an der Montageposition des Batteriefachs (150) montiert ist, auf Basis des Erfassungssignals ein erstes Anzeigesignal zu erzeugen.

8. Stromversorgung (100) nach Anspruch 1, wobei die Erfassungsanordnung (180) eine kontaktlose Erfassungsanordnung (180) umfasst.

9. Stromversorgung (100) nach Anspruch 4, wobei das erste Anzeigesignal ein Niederspannungssignal mit einer Spannung ist, die niedriger ist als ein Spannungswert, und das zweite Anzeigesignal ein Hochspannungssignal mit einer Spannung ist, die höher als oder gleich dem Spannungswert ist.

10. Stromversorgung (100) nach Anspruch 1, wobei, wenn die Stromversorgung (100) an der Montageposition des Batteriefachs (150) montiert ist, mindestens ein Abschnitt des bewegbaren Elements (121, 122) in der ersten Positionsbegrenzungsstruktur (185) aufgenommen ist.

11. Stromversorgung (100) nach Anspruch 1, wobei, wenn die Stromversorgung (100) an der Montageposition des Batteriefachs (150) montiert ist, das bewegbare Element (121, 122) an eine zweite Positionsbegrenzungsstruktur einer Montagehalterung gekoppelt ist.

12. Stromversorgung (100) nach Anspruch 1, wobei das bewegbare Element (121, 122), während die Stromversorgung (100) an der Montageposition des Batteriefachs (150) montiert wird, dazu ausgelegt ist, an einer ersten Seite des Batteriefachs (150) anzuliegen, und unter einer Druckkraft von der ersten Seite des Batteriefachs (150) zur ersten Seite der Positionsbegrenzungsstruktur (185) gedrückt wird.

13. Verfahren zum Bestimmen, dass die Stromversorgung (100) gemäß einem der Ansprüche 1-12 an einer vorbestimmten Montageposition des Batteriefachs (150) montiert ist, wobei das Verfahren Folgendes umfasst:
Detektieren eines Anzeigesignals, das von einer Erfassungsanordnung (180) erzeugt wird, wenn eine erste Seite des bewegbaren Elements (121, 122) mit der ersten Seite der ersten Positionsbegrenzungsstruktur (185) verbunden ist und eine zweite Seite des bewegbaren Elements (121, 122) sich aus dem Gehäuse (106) erstreckt, wenn die Stromversorgung (100) an der Montageposition des Batteriefachs (150) montiert ist;
Bestimmen, ob das Anzeigesignal eine vorbestimmte Bedingung erfüllt; und
Bestimmen, dass die Stromversorgung (100) an der vorbestimmten Montageposition des Batteriefachs (150) montiert ist, auf Basis einer Bestimmung, dass das Anzeigesignal die vorbestimmte Bedingung erfüllt.

14. Bewegbare Plattform, die Folgendes umfasst:
eine Stromversorgung (100); und
einen Körper, der ein Batteriefach (150) zum Montieren der Stromversorgung (100) umfasst, wobei die Stromversorgung (100) eine Stromversorgung (100) gemäß einem der Ansprüche 1-12 ist.

## Revendications

1. Alimentation électrique (100), comprenant :
au moins une batterie ;
une enceinte (106) configurée pour contenir la au moins une batterie ; et
au moins un dispositif de détection (170) configuré pour être couplé à l'enceinte (106) et comprenant
un élément mobile (121, 122),
un ensemble de détection (180), et
une première structure de limitation de position (185),
dans laquelle l'élément mobile (121, 122) est configuré pour être couplé de manière mobile à un premier côté de la structure de limitation de position,
dans laquelle l'ensemble de détection (180) est configuré pour générer un signal d'indication destiné à indiquer si l'alimentation électrique (100) a été montée au niveau d'un emplacement de montage d'un compartiment à batterie (150) sur la base d'un emplacement de l'élément mobile (121, 122),
dans laquelle l'élément mobile (121, 122) est configuré pour se déplacer selon un emplacement de l'alimentation électrique (100), de sorte que l'ensemble de détection (180) génère le signal d'indication destiné à indiquer si l'alimentation électrique (100) a été montée au niveau de l'emplacement de montage du compartiment à batterie (150) sur la base d'un emplacement de l'élément mobile (121, 122), et
dans laquelle un premier côté de l'élément mobile (121, 122) est configuré pour être relié de manière mobile au premier côté de la première structure de limitation de position (185) et un second côté de l'élément mobile (121, 122) est configuré pour s'étendre en-dehors de l'enceinte (106) lorsque l'alimentation électrique (100) est montée au niveau de l'emplacement de montage du compartiment à batterie (150).

2. Alimentation électrique (100) selon la revendication 1, dans laquelle le signal d'indication comprend un premier signal d'indication destiné à indiquer que l'alimentation électrique (100) est montée au niveau de l'emplacement de montage.

3. Alimentation électrique (100) selon la revendication 1, dans laquelle, lorsque l'alimentation électrique (100) est montée au niveau de l'emplacement de montage, l'élément mobile (121, 122) est déplacé vers un emplacement adjacent au premier côté de la première structure de limitation de position (185), et l'ensemble de détection (180) génère un premier signal d'indication destiné à indiquer que l'alimentation électrique (100) est montée au niveau de l'emplacement de montage.

4. Alimentation électrique (100) selon la revendication 2, dans laquelle le signal d'indication comprend en outre un second signal d'indication destiné à indiquer que l'alimentation électrique (100) n'est pas montée au niveau de l'emplacement de montage, de préférence
lorsque l'alimentation électrique (100) n'est pas montée au niveau du compartiment à batterie (150), l'élément mobile (121, 122) ne se trouve pas à l'emplacement adjacent au premier côté de la première structure de limitation de position (185), et l'ensemble de détection (180) génère le second signal d'indication destiné à indiquer que l'alimentation électrique (100) n'est pas montée au niveau de l'emplacement de montage.

5. Alimentation électrique (100) selon la revendication 1, comprenant en outre un élément de restauration (141, 142) configuré pour fournir une force de restauration à l'élément mobile (121, 122).

6. Alimentation électrique (100) selon la revendication 5, dans laquelle deux extrémités de l'élément de restauration sont reliées au premier côté de la première structure de limitation de position (185) et à l'élément mobile (121, 122), respectivement, ou
dans laquelle, lorsque l'alimentation électrique (100) est montée au niveau de l'emplacement de montage, l'élément mobile (121, 122) est déplacé vers l'emplacement adjacent au premier côté de la première structure de limitation de position (185) sous l'effet de la force de restauration de l'élément de restauration, ou
dans laquelle l'élément de restauration est configuré pour être comprimé sous l'effet d'une force exercée par l'élément mobile (121, 122), ou
dans laquelle l'élément de restauration est un élément élastique, ou
dans laquelle l'élément de restauration est au moins partiellement disposé dans la première structure de limitation de position (185).

7. Alimentation électrique (100) selon la revendication 1,
dans laquelle l'ensemble de détection (180) comprend un élément de signalisation (181) et un élément de détection (182), et
dans laquelle l'élément de signalisation est configuré pour générer un signal de détection, et l'élément de détection est configuré pour générer un premier signal d'indication destiné à indiquer que l'alimentation électrique (100) est montée au niveau de l'emplacement de montage du compartiment à batterie (150) sur la base du signal de détection.

8. Alimentation électrique (100) selon la revendication 1, dans laquelle l'ensemble de détection (180) comprend un ensemble de détection sans contact (180).

9. Alimentation électrique (100) selon la revendication 4, dans laquelle le premier signal d'indication est un signal à basse tension ayant une tension inférieure à une valeur de tension, et le second signal d'indication est un signal à haute tension ayant une tension supérieure ou égale à la valeur de tension.

10. Alimentation électrique (100) selon la revendication 1, dans laquelle, lorsque l'alimentation électrique (100) est montée au niveau de l'emplacement de montage du compartiment à batterie (150), au moins une partie de l'élément mobile (121, 122) est reçue dans la première structure de limitation de position (185).

11. Alimentation électrique (100) selon la revendication 1, dans laquelle, lorsque l'alimentation électrique (100) est montée au niveau de l'emplacement de montage du compartiment à batterie (150), l'élément mobile (121, 122) est couplé à une seconde structure de limitation de position d'un support de montage.

12. Alimentation électrique (100) selon la revendication 1, dans laquelle, lorsque l'alimentation électrique (100) est montée au niveau de l'emplacement de montage du compartiment à batterie (150), l'élément mobile (121, 122) est configuré pour buter contre un premier côté du compartiment à batterie (150) et est pressé afin de se déplacer vers le premier côté de la première structure de limitation de position (185) sous l'effet d'une force de pression exercée par le premier côté du compartiment à batterie (150).

13. Procédé de détermination du fait que l'alimentation électrique (100) selon l'une quelconque des revendications 1 à 12 soit montée au niveau d'un emplacement de montage prédéterminé du compartiment à batterie (150), le procédé comprenant :
la détection d'un signal d'indication généré par un ensemble de détection (180) lorsqu'un premier côté de l'élément mobile (121, 122) est relié au premier côté de la première structure de limitation de position (185) et un second côté de l'élément mobile (121, 122) s'étend en-dehors de l'enceinte (106) lorsque l'alimentation électrique (100) est montée au niveau de l'emplacement de montage du compartiment à batterie (150) ;
la détermination du fait que le signal d'indication satisfasse une condition prédéterminée ; et
la détermination du fait que l'alimentation électrique (100) soit montée au niveau de l'emplacement de montage prédéterminé du compartiment à batterie (150) sur la base d'une détermination du fait que le signal d'indication satisfasse la condition prédéterminée.

14. Plate-forme mobile, comprenant :
une alimentation électrique (100) ; et
un châssis comprenant un compartiment à batterie (150) destiné à monter l'alimentation électrique (100),
dans laquelle l'alimentation électrique (100) est une alimentation électrique (100) selon l'une quelconque des revendications 1 à 12.
